**Europäisches Patentamt**

(19) **European Patent Office**

**Office européen des brevets**

(11) Veröffentlichungsnummer: **0 092 518**
**B1**

(12) # EUROPÄISCHE PATENTSCHRIFT

(45) Veröffentlichungstag der Patentschrift:
07.10.87

(51) Int. Cl.⁴: **B 41 J 5/12,** H 03 K 17/97

(21) Anmeldenummer: 83810149.1

(22) Anmeldetag: 13.04.83

(54) Tastenelement.

(30) Priorität: 15.04.82 CH 2282/82

(43) Veröffentlichungstag der Anmeldung:
26.10.83 Patentblatt 83/43

(45) Bekanntmachung des Hinweises auf die Patenterteilung:
07.10.87 Patentblatt 87/41

(84) Benannte Vertragsstaaten:
AT BE CH DE FR GB IT LI NL SE

(56) Entgegenhaltungen:
EP - A - 0 009 420
WO - A - 81/00376
FR - A - 2 164 194
GB - A - 1 521 435
US - A - 3 668 697
US - A - 3 749 859
US - A - 4 202 640

IBM TECHNICAL DISCLOSURE BULLETIN, Band 3, Nr. 6,
November 1960, Seite 15, Stamford, US, D.E. Eastwood:
"Key top"

(73) Patentinhaber: STANDARD TELEPHON UND RADIO AG,
Friesenbergstrasse 75, CH-8055 Zürich (CH)
(84) Benannte Vertragsstaaten: CH LI

(73) Patentinhaber: Alcatel N.V., De Lairessestraat 153,
NL-1075 HK Amsterdam (NL)
(84) Benannte Vertragsstaaten: BE DE FR GB IT NL SE AT

(72) Erfinder: Frey, Werner Urs, Dorfstrasse 96,
CH-8800 Thalwil (CH)
Erfinder: Rometsch, Johannes, Sandweldstrasse,
CH-5635 Rickenbach (CH)
Erfinder: Iseli, Karl, Stoffelweg 1, CH-8820 Wädenswil
(CH)
Erfinder: Wild, Peter, Bolletstrasse 12,
CH-8932 Mettmenstetten (CH)

(74) Vertreter: Bucher, Hans F., Laupenstrasse 15,
CH-3008 Bern (CH)

**Beschreibung**

Die vorliegende Erfindung betrifft ein Tastenelement gemäss dem Oberbegriff des ersten Anspruchs.

Tastenelemente, die sich für eine sog. Trafotastatur eignen, sind bereits im Handel erhältlich. So stellt z.B. die Firma «Mechanical Enterprises» in Sterling, Va. USA ein Tastenelement her, bei welchem jede Taste einen Tastenkopf mit Bezeichnung, einen Stössel mit daran befestigtem ferromagnetischen Kern, einen Sockel mit Führung des Stössels und davon getrenntem Hohlraum zur Aufnahme des Kerns bei unbetätigter Taste und eine Rückstellfeder aufweist. Bei Betätigung der Taste taucht der Kern durch eine Bohrung der Leiterplatte in den auf dieser ausgebildeten Transformator. Die Tasten werden in Durchbrüchen einer Blindplatte befestigt, welche ihrerseits mittels mehrerer die Leiterplatte durchdringender Schrauben auf dieser befestigt ist.

Es ist leicht einzusehen, dass die getrennte Führung des Stössels zu einer grossen Bauhöhe der Tastenreihe führt, was diese für eine nach ergonomischen Gesichtspunkten ausgelegte Tastatur, wie sie z.B. in der Europäischen Patentanmeldung Nr. EP 0055220 beschrieben wird, ungeeignet macht. Ferner müssen für jedes Rastermass unterschiedliche Tastenköpfe vorhanden sein, was wegen des heute üblichen Zweifarbenspritzens für Tastenkopf und Bezeichnung zu kaum tragbaren Werkzeugkosten führt. Weiter besteht bei Unterhaltsarbeiten eine gewisse Bruchgefahr für den durch die Leiterplatte durchtretenden Kern.

Das oben Gesagte gilt weitgehend auch für ein in Fig. 2 der europäischen Patentanmeldung EP-A-0 009 420 im Prinzip dargestelltes Tastenelement. Auch für dieses Tastenelement ist eine meistens aufwendige, im Tastenraster mit Durchbrüchen versehene Blindplatte notwendig, in welche das Tastenelement einschnappbar ist, wobei Führungszapfen für die notwendige Zentrierung des Tastenelementes auf der Leiterplatte sorgen. Die Blindplatte muss mit der darunterliegenden Leiterplatte durch irgendwelche nichtgezeigte Mittel fest verbunden werden. Weiter scheint der Zusammenbau des Tastenelementes mindestens teilweise erst bei dessen Einbau in eine Tastatur möglich zu sein, was die Tastaturmontage und eine allfällige Auswechslung eines Tastenelementes erschwert.

Es ist nun Aufgabe der Erfindung, ein Tastenelement vorzusehen, bei welchem die obigen Nachteile nicht auftreten und bei welchem insbesondere die Werkzeug- und Lagerkosten in einem vertretbaren Rahmen gehalten werden können.

Gelöst wird diese Aufgabe durch die im Kennzeichen des ersten Anspruchs genannten Merkmale. Vorteilhafte Weiterbildungen sind aus den abhängigen Ansprüchen zu entnehmen.

Mit dem vorliegenden Tastenelement lassen sich unterschiedliche Tastaturen gemäss einem Baukastensystem zusammenstellen und die Kalotte mit dem wegen des für die Bezeichnung üblichen Zweifarbenspritzens für jedes Zeichen notwendigen eigenen Werkzeug weist eine sehr einfache Form auf.

Ein Ausführungsbeispiel der Erfindung wird nun anhand der Zeichnung näher erläutert. In der Zeichnung zeigt:

Die Fig. 1 den Sockel des Tastenelementes im Grundriss;

Die Fig. 2 den Stössel des Tastenelementes im Grundriss;

Die Fig. 3 die Kalotte des Tastenelementes in einer Ansicht von unten;

Die Fig. 4 eine teilweise geschnittene Ansicht des Tastenelementes in Explosionsdarstellung;

Die Fig. 5 einen Schnitt durch ein in eine Leiterplatte eingebautes Tastenelement; und

Die Fig. 6 eine teilweise geschnittene Ansicht eines Sockels gemäss Fig. 1, eingebaut in eine Leiterplatte.

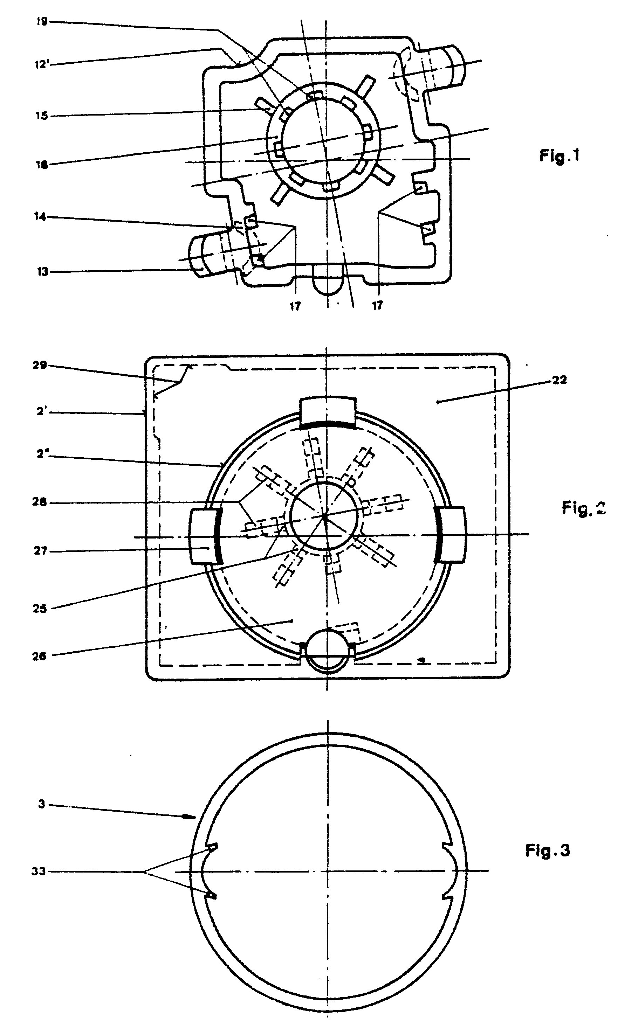

Anhand der Fig. 1–6 werden nun die Einzelteile des Tastenelementes, der Zusammenbau der Einzelteile und die Montage des Tastenelementes auf einer Leiterplatte näher beschrieben. Das Tastenelement besteht aus einem Sockel 1, einem Stössel 2, einer Kalotte 3, einem ferromagnetischen Kern 4 und einem Federelement 5 oder 5'. Die Einzelteile 1, 2 und 3 sind aus Kunststoff hergestellt, vorteilhafterweise in Spritztechnik.

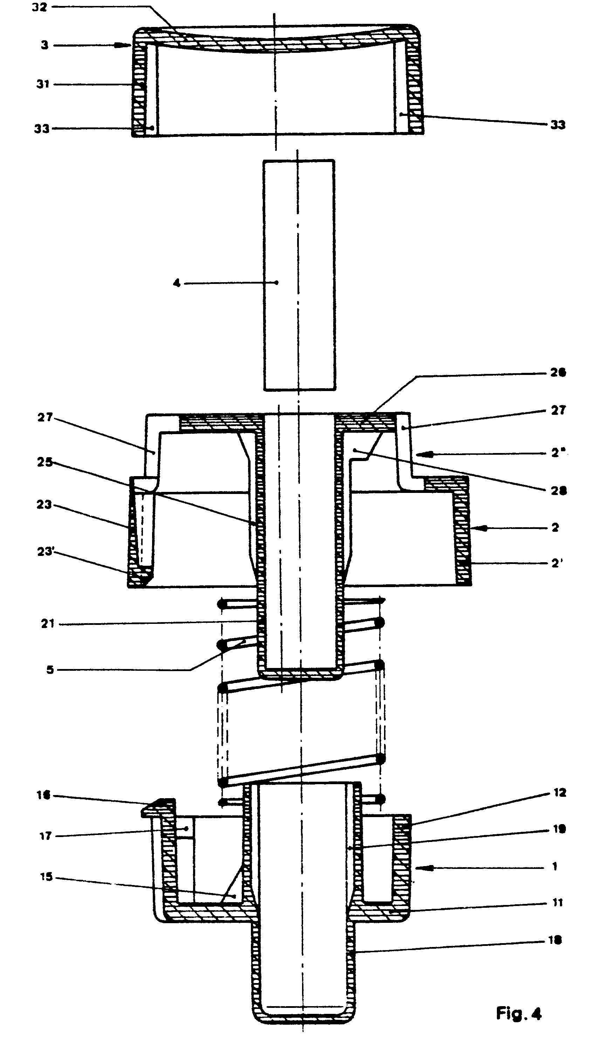

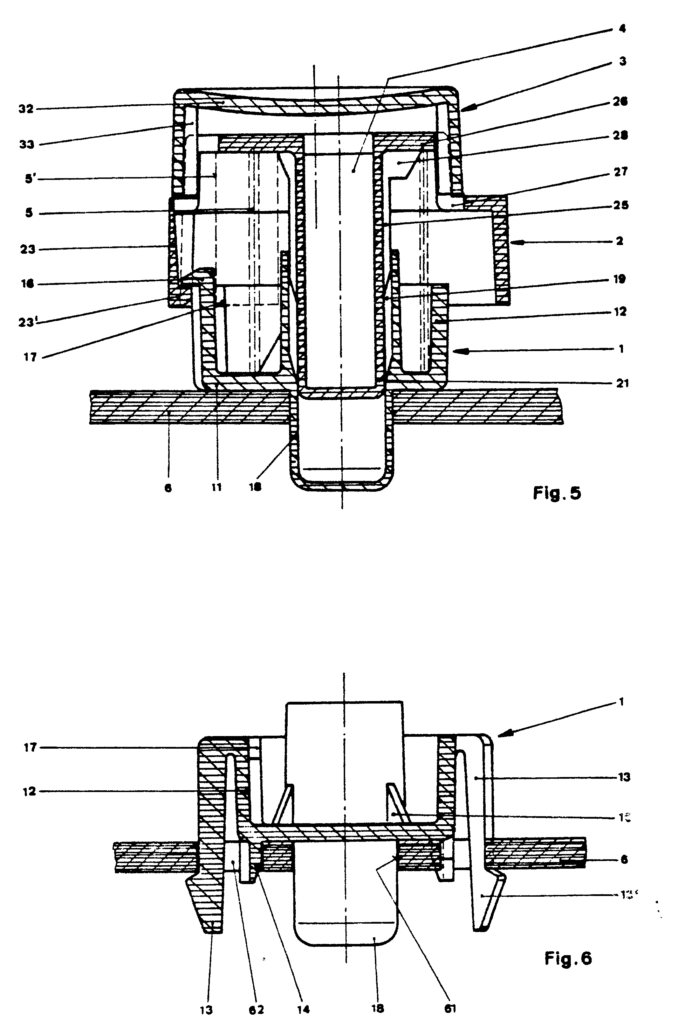

Fig. 1 zeigt den Sockel 1 im Grundriss, während das unterste Element der Explosionsdarstellung von Fig. 4 den Sockel in geschnittener Seitenansicht und die Fig. 6 diesen teilweise geschnitten mit den Details seiner Befestigung auf einer Leiterplatte 6 zeigt. Der Sockel 1 besteht im wesentlichen aus einem nach oben offenen Kasten mit Wänden 12, welcher Kasten einen im Ganzen gesehen quadratischen Grundriss aufweist, und aus einem im Boden 11 des Kastens angeformten zylindrischen Rohr 18, dessen Boden geschlossen ist. An zwei sich diagonal gegenüberliegenden Ecken des Kastens sind am freien, obern Ende der Wände 12 sich nach unten erstreckende Arme 13 angeformt, wie dies aus Fig. 6 gut ersichtlich ist. Diese Arme verhalten sich federnd und erstrecken sich nahezu gleich weit wie das Rohr 18 nach unten. An den untern Enden der Arme sind keilförmige Verbreiterungen 13' mit sanft ansteigender Vorderseite und steil abfallender Rückseite vorhanden.

In den gleichen Ecken wie die Arme 13 sind am Boden 11 hohlzylindersegmentförmige Vorsprünge 14 angeformt, deren untere Enden auf der konvexen Seite angeschrägt sind. Die Vorsprünge 14 dienen der Verdrehsicherung des Tastenelementes bei dessen Einbau in eine Leiterplatte 6, welche pro Tastenelement drei Bohrungen aufweisen muss, nämlich eine Bohrung 61 für den Durchtritt des Rohres 18 und des darin verschiebbaren ferromagnetischen Kerns 4, wie dies später noch erläutert wird, und zwei Bohrungen 62 für die Vorsprünge 14, deren Zylinderradius angenähert dem Radius der Bohrungen 62 entspricht. In den durch die Vorsprünge 14 nicht belegten Teil der Bohrungen 62 können die federnden Arme 13 eingeführt werden, wobei die sanft ansteigende Vorderseite von deren Endverbreiterungen 13' wie auch die Abschrägung der Enden der Vorsprünge 14 die Einführung des Sockels bzw. eines darauf aufgebauten Tastenelementes in die Leiterplatte erleichtern. Die steile Rückseite der Endverbreiterungen 13' bewirkt nach dem Einbau des Tastenelementes eine ohne Hilfe von Werkzeugen lösbare Fixierung des Tastenelementes auf der Leiterplatte und nimmt die Dickentoleranzen der Leiterplatte auf.

Es sind also pro Tastenelement drei Bohrungen in der Leiterplatte notwendig, wobei sowohl der Einbau als auch der Ausbau eines Tastenelementes ohne Werkzeughilfe möglich ist und keine Lötvorgänge erfordert.

Das am Boden 11 des Sockels 1 angeformte Rohr 18 erstreckt sich vom Boden aus mit dem am Ende geschlossenen Teil mit glatten und dünnen Wänden nach unten und mit dem am Ende offenen Teil mit dickerer Wand und mit Nuten 19 etwas über die Höhe der Seitenwände hinaus nach oben. Das Rohr 18 ist das Führungsrohr für ein entsprechend geformtes Rohr des Stössels, das in Zusammenhang mit diesem noch näher erläutert wird.

Gleichmässig über den Umfang des Rohres 18 verteilt sind am Fusse des obern Teiles dieses Rohres vier dreieckförmige Streben 15 vorhanden, welche zusammen mit analogen Streben 28 auf der Unterseite des Stössels 2 zum Zentrieren einer Schraubenfeder 5 (in Fig. 5 durch gestrichelte senkrechte Linien angedeutet) für die Stösselrückstellung dienen.

An zwei Seitenwänden 12 des Sockels 1 sind nur wenig unterhalb deren oberen Enden Nischen 17 vorhanden, die für die Aufnahme der Enden einer Blattfeder 5' zur Stösselrückstellung dienen, die zwischen den Nischen 17 und der Unterseite des Deckels 26 des Stössels 2 derart mäanderartig geformt ist, dass sich bei Betätigung der Taste ein Druckpunkt ergibt. Wie aus Fig. 1 ersichtlich ist, verlaufen die Verbindungslinien zwischen entsprechenden Nischen an gegenüberliegenden Wänden 12 unter einem von 90° abweichenden Winkel zur rechten Seitenwand und die Achse des zylindrischen Rohres 18 nicht durch den Diagonalenschnittpunkt des gedachten Grundrissquadrats des Sockels, sondern etwas oberhalb. Dadurch wird einerseits Platz gewonnen für die Blattfeder, anderseits wird durch die aus Fig. 2 sichtbare entgegengesetzte Versetzung zwischen Stösselrohr 21 und Kalottenaufnahme 2'' erreicht, dass der Auflagepunkt der Blattfeder 5' am Stössel nur wenig gegenüber dem Mittelpunkt der Kalotte versetzt ist.

Wie aus dem obigen ersichtlich ist, ist der Sockel sowohl für die Aufnahme einer Schraubenfeder mit linearer Weg/Kraft-Kennlinie als auch für die Aufnahme einer Blattfeder mit nichtlinearer Weg/Kraft-Kennlinie ausgelegt, je nach Wunsch des Verwenders.

Die in Fig. 1 unten liegende Wand des Sockels 1 weist einen Wandbereich mit geringerer Wandstärke auf, in dessen Mitte ein nach aussen weisender Vorsprung 16 vorhanden ist, der sich nach oben über die Wand 12 hinaus erstreckt, wie dies in Fig. 4 ersichtlich ist. Dieser Vorsprung bewirkt zusammen mit einem gegengleichen Vorsprung 23' an einem am Stössel 2 angeformten Arm 23 einen Anschlag für den durch die Rückstellfeder 5 oder 5' bewirkte Aufwärtsbewegung des Stössels. Beim Zusammenbau von Stössel und Sockel gleiten dabei die beiden Vorsprünge mit ihren gegengleichen Schrägen unter federnder Auslenkung aufeinander, um schliesslich einzurasten, wie dies Fig. 5 zeigt. Dadurch werden Stössel und Sockel unverlierbar, jedoch trennbar miteinander verbunden.

Zusammenfassend kann gesagt werden, dass der Sockel 1 als einstückiges Kunststoffteil alle Elemente enthält, die für die Führung und Hubbegrenzung des Stössels, für den werkzeuglosen und lötfreien Ein- und Ausbau eines Tastenelementes und für die Aufnahme von Rückstellfedern mit unterschiedlicher Weg/Kraft-Kennlinie nötig sind. Die tatsächlichen Abmessungen des gedachten Grundrissquadrates des Sockels betragen ungefähr 12 × 12 mm, so dass der Sockel für Tastenelemente ab einem Rastermass 15 × 15 mm verwendbar ist. Das kleinste Rastermass wird für sog. Management-Tastaturen benützt, während für professionelle Tastaturen grössere Rastermasse üblich sind.

Fig. 2 zeigt den Stössel 2 im Grundriss, während das mittlere Element in der Explosionsdarstellung von Fig. 4 diesen im Schnitt zeigt. Der Stössel 2 besteht im wesentlichen aus einem untern Wandteil 2' mit quadratischem oder rechteckigem Grundriss, dessen Masse und Form durch das vom Verwender gewünschte Rastermass der Tastatur bestimmt sind, aus einem Zwischenboden 22, aus einem obern Wandteil 2'' mit kreisrundem Grundriss, aus einem Deckel 26 und aus einem an letzterem angeformten zylindrischen Rohr 21 mit geschlossenem unteren und offenem oberen Ende.

Der obere, zylindrische Wandteil 2'' des Stössels 2 weist vier je um 90° gegeneinander versetzte Ausnehmungen 27 auf, die zur Halterung der Kalotte 3 in vier verschiedenen Stellungen dienen, wobei alle diese Ausnehmungen durch die aufgesetzte Kalotte dicht verschlossen werden. Die abweichende Kontur der untersten Öffnung 27 in Fig. 2 ist spritztechnisch bedingt und wird nicht weiter erwähnt. Es ist leicht ersichtlich, dass bei aufgesetzter Kalotte 3 noch ein Teil des Zwischenbodens 22, der die beiden Wandteile 2' und 2'' verbindet, sichtbar bleibt, dessen Ausmass abhängig ist von der Form und den Massen des untern Wandteiles 2', die ihrerseits, wie bereits erwähnt, abhängig sind vom Rastermass der Tastatur, für welche das Tastenelement verwendet werden soll. Durch entsprechende Farbwahl des für den Stössel verwendeten Kunststoffes kann eine Tastatur dank des sichtbar bleibenden Teiles des Zwischenbodens 22 farblich leicht in verschiedene Zonen aufgeteilt werden, z.B. für alphanumerische Tasten, numerische Tasten und Funktionstasten.

Der untere Wandteil 2' des Stössels 2 weist eine solche Länge auf, dass dessen unterer Rand in der Ruhestellung des Stössels tiefer liegt als der obere Rand der Wand 12 des Sockels 1. Damit wird erreicht, dass das Tastenelement bei aufgesetzter Kalotte 3 sowohl in unbetätigter als auch in betätigter Stellung praktisch schwallwasserdicht ist. Dies kann bei einem Tastenelement, das z.B. für die Tastatur eines Dateneingabegerätes verwendet wird, von gewissem Wert sein, da es durchaus vorkommen kann, dass Flüssigkeiten über einer Tastatur verschüttet werden.

An der Unterseite des den zylindrischen Wandteil 2″ abschliessenden Deckels 26 ist das bereits erwähnte zylindrische Rohr 21 angeformt, dessen unteres Ende geschlossen ist. Sein Innenraum nimmt den ferromagnetischen Kern 4 auf, der z.B. durch Wärmeverformung der Austrittskante des Rohres fixiert wird. Ähnlich wie beim Rohr 18 des Sockels besitzt auch das Rohr 21 einen untern Teil mit glatten Wänden relativ geringer Wandstärke und einen obern Teil mit einer Anzahl von an der Mantelfläche angeformten Rippen 25, welche nahe beim Deckel 26 in dreieckförmige Streben 28 auslaufen, die, wie bereits erwähnt, der Zentrierung der Schraubenfeder 5 dienen. Die Rippen 25 gleiten beim Betätigen der Taste in den Nuten 19 des Sockels und bewirken damit einen Schutz gegen das Drehen des Stössels im Sockel und eine Verstärkung des Rohres 21. Gleichzeitig vergrössern diese Rippen den Fliessquerschnitt von der Einspritzstelle im Boden des Rohres 21 zu den Seitenwänden 2″ und 2′. Gleichzeitig bewirkt das zwischen den Rippen 25 und den Nuten 19 vorhandene Spiel ein einfaches Entweichen der bei der Tastenbetätigung aus dem Rohr 18 verdrängten Luft.

Eine Ecke der Seitenwand 12 des Sockels 1 weist eine in Fig. 1 sichtbare Hohlkehle 12′ auf, während die Wandstärke des quadratischen oder rechteckigen Teiles 2′ der Seitenwand des Stössels 2 an der Stelle 29 geringer ist, wie dies aus Fig. 2 sichtbar ist. Diese beiden Massnahmen dienen zusammen mit einer nicht gezeigten Bohrung im Zwischenboden 22, die durch eine durchscheinende Abdeckung verschlossen ist, dazu, die Möglichkeit für den Einbau einer in die Leiterplatte eingelöteten lichtemittierenden Diode als Kontrollleuchte zu schaffen, wie dies manchmal für Sondertasten gewünscht wird.

Dank der Aufteilung der Rohre 18 und 21 in je einen dünnwandigen unteren Teil und einen verstärkten oberen Teil kann erreicht werden, dass der Luftspalt zwischen dem ferromagnetischen Kern 4 und den Wicklungen des Tastentransformators kaum grösser wird als bei einer Anordnung mit den im Stand der Technik genannten Tasten, bei welcher Anordnung der Kern unverhüllt durch die Leiterplatte durchtritt, aber wegen der Fertigungstoleranzen eine relativ grosse Durchtrittsbohrung gewählt werden muss.

Die Fig. 3 zeigt die Kalotte 3 in einer Ansicht von unten, während sie in Fig. 4 und 5 im Schnitt sichtbar ist. Die Kalotte 3 besteht aus einem Kunststoffteil mit einer praktisch zylindrischen Wand 31 und einem als konkave bis konvexe Grifffläche ausgebildeten Deckel 32. An der Innenseite der Wand 31 sind an zwei sich gegenüberliegenden Stellen zur Zylinderachse parallel verlaufende Paare von lippenförmigen Vorsprüngen 33 angeformt, welche unter federnder Verformung in die Ausnehmungen 27 des Stössels 2 passen und so der Halterung der Kalotte auf dem Stössel dienen.

Die Kalotte kann aus transparentem Kunststoff hergestellt sein. In diesem Falle kann in den in Fig. 5 sichtbaren Zwischenraum zwischen Stössel und trennbaren Kalottenunterseite ein Bezeichnungsschild eingelegt werden, was für Prototyp-Tastaturen einen Vorteil bieten kann. Für professionelle Tastaturen dürften die Kalotten und ihre Bezeichnungen eher im Zweifarben-Spritzverfahren hergestellt werden. Da bei diesem Spritzverfahren für jedes Zeichen ein eigene Werkzeugkavität vorhanden sein muss, ist es sehr wichtig, dass die Form des herzustellenden Teiles möglichst einfach ist.

Es ist leicht einzusehen, dass sich durch die vorliegende Aufteilung des Tastenelementes in einen einheitlichen Sockel mit den Elementen für die Zentrierung und Halterung des Tastenelementes auf einer Leiterplatte und für die Führung des Stössels, in einen Stössel mit vom gewünschten Tastaturraster abhängigen Abmessungen, der den ferromagnetischen Kern innerhalb der Führung aufnimmt, und in eine einheitliche Kalotte mit einer geringen Anzahl unterschiedlicher Werkzeugkavitäten und einer relativ geringen Anzahl von an Lager zu haltenden Teilen eine ganze Tastaturfamilie abgedeckt werden kann.

Dank ihrer geringen Bauhöhe eignen sich Tastenelemente der vorliegenden Art insbesondere für die Verwendung in flachen, auf Arbeitsflächen aufliegenden Tastaturen von Datenendgeräten, Textsystemen usw. Es ist mit diesen Tastenelementen kein Problem, die nach DIN 33402 geforderte maximale Höhe von 30 mm ab Auflagefläche der Tastatur für die dritte Tastenreihe von unten zu unterschreiten.

**Patentansprüche**

1. Tastenelement für eine kontaktlose Tastatur, bei welcher für die Tastenbetätigung das Eintauchen eines ferromagnetischen Kernes in einen auf einer Leiterplatte ausgebildeten Tastentransformator notwendig ist, mit einem in einem Sockel (1) geführten und mit dem ferromagnetischen Kern (4) verbundenen Stössel (2), und mit zwischen Sockel und Stössel angeordneten Federmitteln (5, 5′) zur Rückführung des Stössels in die Ruhelage, gekennzeichnet durch Elemente zur Sicherung des Sockels gegen Verdrehung (14) und zur schraubenlosen und lötfreien Befestigung (13) desselben unmittelbar auf der Leiterplatte (6), durch beim Zusammenbau von Stössel und Sockel einrastende Hubbegrenzungsmittel (16, 23) und durch eine auf dem Stössel halterbare Kalotte (3).

2. Tastenelement nach Anspruch 1, dadurch gekennzeichnet, dass der Sockel (1) aus einem einstückigen einen als Auflage auf der Leiterplatte (6) dienenden Boden (11), Seitenwände (12) und ein am Boden angeformtes zylindrisches Rohr (18) aufweisenden Kunststoffteil besteht, und dass das zylindrische Rohr einen untern, über die Auflagefläche vorspringenden, als Zentrierhilfe dienenden und am Ende geschlossenen Teil mit glatten Wänden und einen obern, offenen Teil mit achsparallelen Nuten (19) an der Innenwand aufweist.

3. Tastenelement nach Anspruch 2, dadurch gekennzeichnet, dass die Elemente zur Verdrehsicherung aus zwei sich diametral gegenüberliegenden, am Boden (11) des Sockels angeformten, hohlzylindersegmentförmigen Vorsprüngen (14) bestehen, deren untere Enden auf der konvexen Seite angeschrägt sind, und dass die Befestigungselemente aus den Elementen für die Verdrehsicherung benachbarten, am obern Ende der Seitenwand (12) angeformten, über die Auflagefläche hinausragenden, federnden Armen (13) mit keilförmig verbreiterten Enden (13') bestehen, das Ganze derart, dass sich jeweils ein Verdrehsicherungselement und ein Befestigungselement zusammen in dieselbe kreisrunde Bohrung (61) der Leiterplatte einführen lassen, wobei die Abschrägung der Verdrehsicherungselemente und die Vorderseite der keilförmigen Verbreiterungen der federnden Arme die Einführung erleichtern und die Rückseite der keilförmigen Verbreiterungen für eine trennbare Befestigung des Sockels auf der Leiterplatte sorgen.

4. Tastenelement nach Anspruch 3, dadurch gekennzeichnet, dass der Stössel (2) aus einem einstückigen Kunststoffteil mit Seitenwänden (2', 2''), mit einem Deckel (26) und mit einem an diesem angeformten zylindrischen Rohr (21) besteht, dass das zylindrische Rohr einen über die untere Kante der Wände vorspringenden und am Ende geschlossenen Teil mit glatten Wänden und einen obern, offenen Teil mit achsparallelen Rippen (25) an der Aussenwand aufweist, wobei der Aussendurchmesser des zylindrischen Rohres und die Abmessungen seiner Rippen so gewählt sind, dass sich ein Gleitsitz im zylindrischen Rohr (18) und den Nuten (19) des Sockels ergibt, wobei die Rippen und Nuten eine Verdrehsicherung zwischen Stössel und Sockel bewirken.

5. Tastenelement nach Anspruch 4, dadurch gekennzeichnet, dass die Seitenwände des Stössels einen untern Teil (2') mit rechteckigem oder quadratischem Grundriss und einen obern hohlzylinderförmigen Teil (2'') mit vier gleichmässig auf dem Umfang verteilten Ausschnitten (27) aufweisen, welche Teile durch einen horizontal verlaufenden Zwischenboden (22) miteinander verbunden sind, wobei die Achse des hohlzylinderförmigen Teiles nicht durch den Schnittpunkt der Diagonalen des Grundrisses des untern Teiles läuft.

6. Tastenelement nach Anspruch 5, dadurch gekennzeichnet, dass die Kalotte (3) aus einem einstückigen, mit einer praktisch zylindrischen Wand (31) und mit einem als konkave bis konvexe Grifffläche ausgebildeten Deckel (32) versehenen Kunststoffteil besteht, und dass die zylindrische Wand an zwei gegenüberliegenden Stellen zur Zylinderachse parallel verlaufende, lippenförmige Vorsprünge (33) aufweist, welche zur trennbaren Halterung der Kalotte auf dem obern Teil (2'') des Stössels dienen.

7. Tastenelement nach Anspruch 6, dadurch gekennzeichnet, dass die Kalotte (3) entweder aus transparentem Kunststoff besteht, so dass ein zwischen Stösseloberteil (2'') und Kalotte eingelegtes Bezeichnungsschild sichtbar ist, oder zweifarbig ist, wobei die Bezeichnung eine andere Farbe aufweist als der Rest der Kalotte.

8. Tastenelement nach Anspruch 7, dadurch gekennzeichnet, dass im Sockel (1) am Fusse des obern Teiles des zylindrischen Rohres (18) aussen dreieckförmige Streben (15) vorhanden sind, welche mit am obern Ende des zylindrischen Rohres (21) des Stössels (2) aussen angeformten dreieckförmigen Streben (28) zusammenwirken, um eine der Rückstellung des Stössels dienende Schraubenfeder (5) zu zentrieren.

9. Tastenelement nach Anspruch 7, dadurch gekennzeichnet, dass an zwei sich gegenüberliegenden Seitenwänden Nischen (17) vorhanden sind, welche zur Aufnahme der Enden einer Blattfeder (5') dienen, welche zwischen den Nischen und der Unterseite des Deckels (26) des Stössels (2) derart mäanderartig geformt ist, dass sich bei Betätigung der Taste ein Druckpunkt ergibt.

10. Tastenelement nach Anspruch 8 oder 9, dadurch gekennzeichnet, dass die Hubbegrenzungsmittel beim Sockel (1) einen in der Mitte einer der Seitenwände (12) über den obern Rand der Wand und nach aussen ragenden Vorsprung (16) aufweisen und beim Stössel (2) einen an der entsprechenden Stelle des Zwischenbodens (22) angeformten, sich nach unten erstreckenden Arm (23) mit einem Vorsprung (23') am untern Ende, das Ganze derart, dass beim Zusammenbau von Sockel und Stössel die beiden Vorsprünge mit ihren gegengleichen Schrägen unter federnder Auslenkung der Vorsprünge aufeinander gleiten und anschliessend einrasten, wobei in der eingerasteten Stellung der untere Rand des untern Teiles (2') der Wand des Stössels tiefer liegt als der obere Rand der Wand des Sockels, so dass bei aufgesetzter Kalotte (3) das Tastenelement praktisch schwallwassergeschützt ist.

11. Tastenelement nach Anspruch 10, dadurch gekennzeichnet, dass eine Ecke der Seitenwand (12) des Sockels (1) eine Hohlkehle (12') aufweist, dass die Wand des quadratischen oder rechteckigen Teiles (2') der Seitenwand des Stössels (2) im Bereiche einer Ecke (29) eine geringere Wandstärke aufweist, und dass der Zwischenboden (22) des Stössels mit einem mit einer durchscheinenden Abdeckung verschlossenen Durchbruch versehen ist, das Ganze derart, dass in die Leiterplatte (6) eine in den Hohlraum zwischen der Hohlkehle des Sockels und der Wand des Stössels hineinragende lichtemittierende Diode als Signalleuchte einbaubar ist.

## Claims

1. Key element for a contactless keyboard wherein for operating a key the insertion of a ferromagnetic core into a key transformer formed on a printed circuit board is needed including a stem (2) guided by a base (1) and connected to the ferromagnetic core (4) and spring means (5, 5') arranged between the base and the stem to reset the stem into the rest position, characterized by comprising elements (14) to protect the base against rotation and elements (13) to fix it directly onto the printed circuit board (6) without screws and without soldering operations, stroke limiting means (16, 23) locking-on when the stem and the base are assembled, and a cap (3) mountable on the stem.

2. Key element according to claim 1, characterized in that the base (1) is a plastic moulded piece with a bottom (11) used as the bearing surface on the printed circuit board (6), with side walls (12) and with a cylindric tube (18) integral with the bottom, and that the cylindric tube comprises a lower closed portion with a smooth wall projecting over the bearing surface and being used as a centering help and an upper open portion with grooves (19) on the inner side of the wall extending in parallel to its axis.

3. Key element according to claim 2, characterized in that the elements for protecting against rotation consist of two projections (14) integral with the bottom (11) of the base and having a hollow-cylinder segment shape the lower ends of which are sloped at the convex side, and that the fixing elements consist of resilient arms (13) with wedge-shaped enlargements (13') extending over the bearing surface and being adjacent to the elements for the protection against rotation, the arrangement being such that one element for protection against rotation and one fixing element can be inserted into the same circular bore (61) of the printed circuit board, the sloped surface of the elements for protection against rotation and the front side of the wedge-shaped enlargements of the resilient arms facilitating the insertion into the printed circuit board and the rear side of the wedge-shaped enlargements providing a separable fixing of the base on the printed circuit board.

4. Key element according to claim 3, characterized in that the stem (2) is a plastic moulded piece with side walls (2', 2''), with a cover (26) and with a cylindric tube (21) integral with the cover for receiving the ferromagnetic core, that the cylindric tube comprises al lower portion with a smooth wall extending over the lower end of the side walls and being closed at its end and an upper open portion with ribs (25) on the outer side of the wall in parallel to the tube axis, the outer diameter of the cylindric tube and the size of its ribs being so chosen that there results a sliding fit in the cylindric tube (18) and in the grooves (19) of the base, the ribs and the grooves insuring a protection against a rotation of the stem relative to the base.

5. Key element according to claim 4, characterized in that the side walls of the stem comprise a lower portion (2') having a square or rectangular plan view and an upper hollow-cylinder-shaped portion (2'') having on its circumference four equally spaced recesses (27) which two portions are interconnected by a horizontally arranged intermediate bottom (22), the axis of the hollow-cylinder-shaped part passing outside the crosspoint of the diagonals of the plan view of the lower portion.

6. Key element according to claim 5, characterized in that the cap (3) consists of a plastic moulded piece with a substantially cylindrical wall (31) and a cover (32) designed as a concave to convex finger board, and that at two adjacent positions the cylindric wall is provided with lip-like projections (33) extending in parallel to the axis of the cylinder which are used for detachably fixing the cap onto the upper portion (2'') of the stem.

7. Key element according to claim 6, characterized in that either the cap (3) consists of transparent plastic material so that a label inserted between the upper portion (2'') of the stem and the cap is visible or the cap is two-coloured whereby the marking has another colour than the remainder of the cap.

8. Key element according to claim 7, characterized in that at the bottom of the upper portion of the cylindric tube (18) of the base there are provided at the outer side triangular struts (15) co-operating with similar triangular struts (28) at the upper end of the cylindric tube (21) of the stem (2) in order to center a helical spring (5) for resetting the stem.

9. Key element according to claim 7, characterized in that at two adjacent side walls of the base (1) there are provided niches (17) used for receiving the ends of a leaf spring (5') which is meander-like shaped between the niches and the lower side of the cover (26) of the stem (2) in such a manner that when operating the key there results a pull-off.

10. Key element according to claims 8 or 9, characterized in that the stroke limiting means comprise for the base (1) a projection (16) projecting in the middle of one of the side walls (12) over the upper end of the wall to the outside and for the stem (2) an arm (23) formed at the corresponding position of the intermediate bottom (22) and extending downwards and having a projection (23') at the lower end, the arrangement being such that when the base and the stem are assembled the two projections slide over their respective sloped surfaces with a resilient displacement of the projections and then lock-on, in the locked position the lower end of the lower portion (2') of the wall of the stem being lower than the upper end of the wall of the base so that the key element with the cap (3) in place in substantially splash-proof.

11. Key element according to claim 10, characterized in that one corner of the side wall (12) of the base (1) is provided with a groove (12'), that the wall of the square or rectangular portion (2') of the side wall of the stem (2) has a corner (29) with a lower wall thickness, and that the intermediate bottom (22) of the stem is provided with a bore closed with a translucent cover, the arrangement being such that a light emitting diode can be mounted on the printed circuit board (6) as a signal lamp which projects into the space between the groove of the base and the wall of the stem.

## Revendications

1. Elément de touche pour clavier sans contacts dans lequel, à l'actionnement d'une touche, il faut qu'un noyau ferromagnétique soit inséré dans un transformateur de touche agencé sur une carte à circuit imprimé, comprenant une tige (2) guidée dans une base (1) et couplée à un noyau ferromagnétique (4), des moyens de ressort (5, 5') disposés entre la base et la tige pour rappeler la tige dans une position de repos, caractérisé en ce qu'il comprend des éléments (14), pour empêcher la rotation de la base, et des éléments (13) pour fixer l'élément de touche sur la carte à circuit imprimé (6), sans vis ni d'opération de soudure, des moyens de limitation de course (16, 23) venant en appui lorsque la tige et la base sont assemblées et un capot (3) pouvant être monté sur la tige.

2. Elément de touche selon la revendication 1, caractérisé en ce que la base (1) est une pièce en matière plastique moulée comportant un fond (11) reposant sur la carte à circuit imprimé (6), des parois latérales (12) et un tube cylindrique (18) prolongeant le fond, et en ce que le tube cylindrique comprend une partie inférieure à paroi lisse, fermée à une extrémité, dépassant de la surface d'appui et utilisée comme moyen de centrage, et une partie supérieure ouverte pourvue de rainures (19) parallèles à l'axe, pratiquées dans sa paroi intérieure.

3. Elément de touche selon la revendication 2, caractérisé en ce que les éléments empêchant la rotation consistent en deux saillies (14) diamétralement opposées formées sur le fond (11) de la base et ayant une forme de segment de cylindre creux, dont l'extrémité inférieure est inclinée vers le côté convexe, et en ce que les éléments de fixation consistent en bras élastiques (13) pourvus de parties élargies en forme de coins (13') formées à la partie supérieure des parois latérales (12), dépassant de la surface d'appui et disposés auprès des éléments empêchant la rotation, ces dispositions étant telles qu'un élément empêchant la rotation et un élément de fixation peuvent être introduits dans un perçage circulaire correspondant (61) de la carte à circuit imprimé, la surface inclinée de l'élément empêchant la rotation et le côté avant de la partie élargie en forme de coin des bras élastiques facilitant l'insertion dans la carte à circuit imprimé, tandis que la partie arrière de la partie élargie en forme de coin fournit une fixation séparable de la base sur la carte à circuit imprimé.

4. Elément de touche selon la revendication 3, caractérisé en ce que la tige (2) est une pièce en matière plastique moulée ayant des parois latérales (2', 2''), un couvercle (26) et un tube cylindrique (21) prolongeant le couvercle, en ce que le tube cylindrique comprend une partie à paroi lisse dépassant le bord inférieur des parois latérales et dont l'extrémité est fermée et une partie supérieure ouverte dotée d'arêtes (25) parallèles à l'axe sur sa paroi extérieure, le diamètre extérieur du tube cylindrique et la dimension des arêtes étant choisis de manière que l'on obtienne un assemblage glissant entre le tube cylindrique (18) et les rainures (19) de la base, les arêtes et les rainures empêchant toute rotation de la tige par rapport à la base.

5. Elément de touche selon la revendication 4, caractérisé en ce que les parois latérales de la tige comprennent une partie inférieure (2') ayant en plan une section carrée ou rectangulaire et une portion supérieure en forme de cylindre creux (2'') ayant sur sa circonférence, quatre évidemment également espacés (27), ces deux parties étant interconnectées par un fond intermédiaire (22) disposé horizontalement, l'axe de la partie en forme de cylindre creux passant en dehors du point de croisement des diagonales de la vue en plan de la partie inférieure.

6. Elément de touche selon la revendication 5, caractérisé en ce que le capot (3) consiste en une pièce moulée en matière plastique comprenant une paroi sensiblement cylindrique (31) et un couvercle (32) conçu comme un appui de doigt concave ou convexe, et en ce que la paroi cylindrique est pourvue, en deux emplacements adjacents de projections en forme de lèvre (33) s'étendant parallèlement à l'axe du cylindre qui sont utilisées pour fixer de manière détachable le capot sur la partie supérieure (2'') de la tige.

7. Elément de touche selon la revendication 6, caractérisé en ce que le capot (3) consiste en un matériau plastique transparent de sorte qu'une étiquette insérée entre la partie supérieure (2'') de la tige et le capot soit visible, ou alors le capot est en deux couleurs, de sorte que le marquage ait une autre couleur que le reste du capot.

8. Elément de touche selon la revendication 7, caractérisé en ce que, au fond de la partie supérieure du tube cylindrique (18) de la base, deux entretoises triangulaires (15) sont prévues du côté extérieur coopérant avec des entretoises triangulaires similaires (28) à l'extrémité supérieure du tube cylindrique (21) de la tige (2) afin de centrer un ressort hélicoïdal (5) de rappel de la tige.

9. Elément de touche selon la revendication 7, caractérisé en ce que, dans deux parois latérales adjacentes de la base (1) sont prévues des niches (17) utilisées pour recevoir les extrémités d'un ressort à lame (5') en forme de méandre entre les niches et le côté inférieur du couvercle (26) de la tige (2), de manière qu'il en résulte une force de renvoi à l'actionnement d'une touche.

10. Elément de touche selon la revendication 8 ou 9, caractérisé en ce que les moyens de limitation de course comprennent, pour la base (1), une saillie (16) dépassant vers l'extérieur, au milieu d'une des parois latérales (12), au-dessus du bord supérieur de la paroi et, pour la tige (2), un bras (23) formé, dans une position correspondante, à partir du fond intermédiaire (22), s'étendant vers le bas et comportant une saillie (23') à son extrémité inférieure, ces dispositions étant telles que, lorsque la base et la tige sont assemblées les deux saillies glissent sur leurs surfaces inclinées respectives, tout en se déplaçant de façon élastique, puis s'encliquètent, le bord inférieur de la partie inférieure (2') de la paroi de la tige étant alors plus bas que le bord supérieur de la paroi de la base, de sorte que l'élément de touche, capot (3) en place, est sensiblement résistant aux éclaboussements.

11. Elément de touche selon la revendication 11, caractérisé en ce que l'un des coins de la paroi latérale (12) de la base (1) est pourvu d'une rainure (12'), en ce que la paroi de la partie carrée ou rectangulaire (2') de la paroi latérale de la tige (2) comprend un coin (29) dans lequel l'épaisseur de paroi est moindre et en ce que le fond intermédiaire (22) de la tige est pourvu d'un orifice fermé par un couvercle transparent, ces dispositions étant telles qu'une diode photo-émissive peut être montée sur la carte à circuit imprimé (6) pour servir de lampe de signalisation projetant de la lumière dans l'espace situé entre la rainure de la base et la paroi de la tige.

Fig.1

Fig.2

Fig.3

0 092 518

Fig. 4

Fig. 5

Fig. 6